# FASCICULE DE BREVET EUROPEEN

(11) **EP 1 223 614 B1**
(45) Date de publication et mention de la délivrance du brevet: **13.12.2006**
(21) Numéro de dépôt: 02290038.5
(22) Date de dépôt: 09.01.2002
(51) Int. Cl.: H01L 21/762

(54) **Procédé de fabrication d'un substrat monocristallin, et circuit intégré comportant un tel substrat**
Verfahren zur Herstellung eines monokristallinen Substrats und integrierter Schaltkreis mit einem solchen Substrat
Method for making a monocristalline substrate and integrated circuit comprising such a substrate

(30) Priorité: 12.01.2001 FR 0100414
(43) Date de publication de la demande: 17.07.2002
(73) Titulaire: STMicroelectronics S.A., 92120 Montrouge (FR)
(72) Inventeur: Menut, Olivier, 38000 Grenoble (FR); Gris, Yvon, 38210 Tullins (FR)
(74) Mandataire: Casalonga, Axel

(56) Documents cités:
- US-A- 4 649 625
- US-A- 4 942 554
- PATENT ABSTRACTS OF JAPAN vol. 012, no. 189 (E-616), 2 juin 1988 (1988-06-02) & JP 62 293759 A (MATSUSHITA ELECTRIC IND CO LTD), 21 décembre 1987 (1987-12-21)

## Description

L'invention concerne les circuits intégrés, et plus particulièrement la préparation d'un substrat initial monocristallin, par exemple en silicium, présentant une discontinuité du réseau cristallin, telle qu'une tranchée enterrée, en vue de la croissance par épitaxie d'une couche de silicium monocristallin homogène. L'invention concerne également des dispositifs semi conducteurs réalisés sur de tels substrats.

Les procédés de fabrication des composants semiconducteurs peuvent détruire la continuité cristalline de la surface d'une partie du substrat initial semiconducteur monocristallin. C'est notamment le cas lors de la réalisation de tranchées que l'on remplit afin de réaliser une isolation diélectrique, un condensateur, ou bien une jonction. Le substrat semiconducteur présente, à l'endroit de la tranchée, un matériau différent sans structure cristalline. Dans le brevet US-A-4 942 554, une cavité réalisée dans un substrat est recouverte d'une couche qui a une composition analogue à celle du substrat et qui est recuit dans un second temps. Dans ce cas, le substrat semiconducteur présente à l'endroit de la tranchée, un matériau analogue à celui du substrat. La surface de la partie du substrat occupée par la tranchée, ou plus généralement par tout autre défaut cristallin localisé, est inutilisable pour réaliser des dispositifs semiconducteurs, en particulier des jonctions ou bien des oxydes thermiques fins.

En effet, les jonctions traversées par un défaut cristallin présentent des courants de fuite. Les oxydes ayant crû à partir d'un défaut cristallin présentent des faibles tensions de claquage ou des courts-circuits.

L'invention vise à apporter une solution à ces problèmes.

Un but de l'invention est de permettre la réalisation d'un substrat monocristallin autorisant la formation ultérieure d'une couche épitaxiale de silicium exempte de défauts cristallins.

Plus précisément, l'invention a notamment pour but de préparer un substrat monocristallin permettant de réparer les défauts localisé de surface et d'assurer une planéité et une homogénéité de surface ainsi qu'une continuité du réseau cristallin de cette surface.

L'invention propose donc un procédé de fabrication d'un substrat monocristallin semiconducteur, dans lequel
a) on élabore un substrat initial monocristallin présentant localement et en surface au moins une discontinuité du réseau cristallin,
b) on évide le substrat initial au niveau de la discontinuité,
c) on amorphise le réseau cristallin en périphérie de l'évidement,
d) on dépose sur la structure obtenue à l'étape c) une couche de matière amorphe ayant la même composition chimique que celle du substrat initial,
e) on effectue un recuit thermique de la structure obtenue à l'étape d) afin de recristalliser la matière amorphe en continuité avec le réseau monocristallin du substrat initial.
L'invention permet donc par exemple de réaliser en surface une couche de silicium monocristallin qui, en continuité avec le reste du substrat initial en silicium, offre une surface parfaitement plane et uniforme sur laquelle on peut développer par épitaxie une couche de silicium monocristallin exempte de défaut cristallin.

Le procédé peut comprendre, préalablement ou postérieurement à l'étape e), une étape d'aplanissement de surface, par exemple un polissage mécano-chimique.

Dans l'étape c), l'amorphisation est localisée et avantageusement auto-alignée avec la discontinuité.

Le substrat initial comporte par exemple au moins un matériau pris dans le groupe formé par le silicium, le germanium, le carbure de silicium, l'arséniure de gallium,et un alliage de certains au moins des éléments précédents.

L'étape d'amorphisation comporte par exemple une implantation ionique localisée autour de l'évidement par une opération de masquage. L'implantation peut utiliser des particules lourdes, par exemple des ions fluorures.

L'invention s'applique avantageusement lorsque la discontinuité du réseau cristallin est formée par une tranchée .

Ainsi, selon un mode de mise en oeuvre, dans l'étape a), on dépose successivement sur le substrat initial une première couche d'un premier matériau, par exemple du dioxyde de silicium, et une deuxième couche d'un deuxième matériau, par exemple du nitrure de silicium, puis on grave une tranchée que l'on remplit avec un matériau de remplissage, ladite tranchée remplie formant ladite discontinuité de réseau cristallin.

Dans l'étape b), on effectue une gravure sélective vis-à-vis de ladite deuxième couche, de la première couche et d'une partie supérieure du matériau de remplissage de la tranchée, de façon à former des cavités latérales et ledit évidement au niveau de la discontinuité cristalline, et on retire ladite deuxième couche.

Le matériau de remplissage peut comporter au moins un élément pris dans le groupe formé par le silicium, un oxyde de silicium, un nitrure de silicium. Le remplissage peut être hétérogène et utiliser plusieurs types d'isolants. Il peut également comporter en son centre un matériau conducteur, par exemple du polysilicium dopé ou non, ou de l'air, ou être partiellement remplie d'un matériau de remplissage isolant avec de l'air au milieu.

Le remplissage peut s'effectuer par dépôt conforme d'oxyde de silicium, ou encore par oxydation thermique du silicium.

Dans l'étape a), on peut réaliser dans la tranchée un condensateur enterrée.

Dans ce cas, le remplissage de la tranchée peut comprendre les étapes suivantes :
- on tapisse les parois de la tranchée avec de l'oxyde par oxydation thermique ;
- on dépose du silicium polycristallin fortement dopé dans la tranchée de manière à la remplir ;
- on grave le silicium polycristallin déposé précédemment de manière à ce que le niveau de remplissage de la tranchée soit en dessous de la surface du substrat initial.

Dans l'étape a), on peut réaliser dans la tranchée une diode enterrée.

Dans ce cas, le remplissage de la tranchée peut comprendre les étapes suivantes :
- on dépose du silicium polycristallin fortement dopé dans la tranchée de manière à la remplir ;
- on grave le silicium polycristallin déposé précédemment de manière à ce que le niveau de remplissage de la tranchée soit en dessous de la surface du substrat initial.

D'une façon générale selon l'invention, l'obturation des tranchées par un "bouchon" de matériau (silicium par exemple) monocristallin permet par ailleurs une plus grande liberté en ce qui concerne la largeur et la nature des tranchées réalisées.

La demanderesse a constaté que ce degré de liberté supplémentaire permet, de manière avantageuse, de réaliser des composants électroniques enterrés dans un substrat. La réalisation de composants électroniques enterrés, tels que capacités ou diodes, se traduit pour des dispositifs semi conducteurs réalisés ultérieurement sur des substrats à surface uniformisée, par un gain de place et de performance et de fonctionalité.

L'invention a également pour objet un circuit intégré, comprenant un substrat en silicium monocristallin réalisé conformément au procédé défini ci-avant.

Ce circuit peut comprendre au moins deux transistors adjacents, par exemple de technologie CMOS ou BiCMOS, réalisés au sein dudit substrat comportant au moins une tranchée enterrée et dont la surface est uniformisée conformément au procédé ci-avant. Ladite tranchée forme une tranchée isolante séparant les couches enterrées contiguës des transistors.

D'autres avantages et caractéristique de l'invention apparaîtront à l'examen de la description détaillée de variantes de réalisation, nullement limitatives.

Ces variantes seront décrites par référence aux figures annexées qui représentent schématiquement les étapes principales de variantes du procédé de fabrication d'un substrat selon l'invention.

Les figures 1a à 1h représentent schématiquement les étapes principales du procédé de fabrication d'un substrat d'un semi conducteur comportant au moins une tranchée isolante.

Les figures 2a à 2f représentent schématiquement les étapes principales du procédé de fabrication d'un substrat semi conducteur comportant au moins une capacité enterrée.

Les figures 3a à 3d représentent schématiquement les étapes principales du procédé de fabrication d'un substrat semi conducteur comportant au moins une diode enterrée.

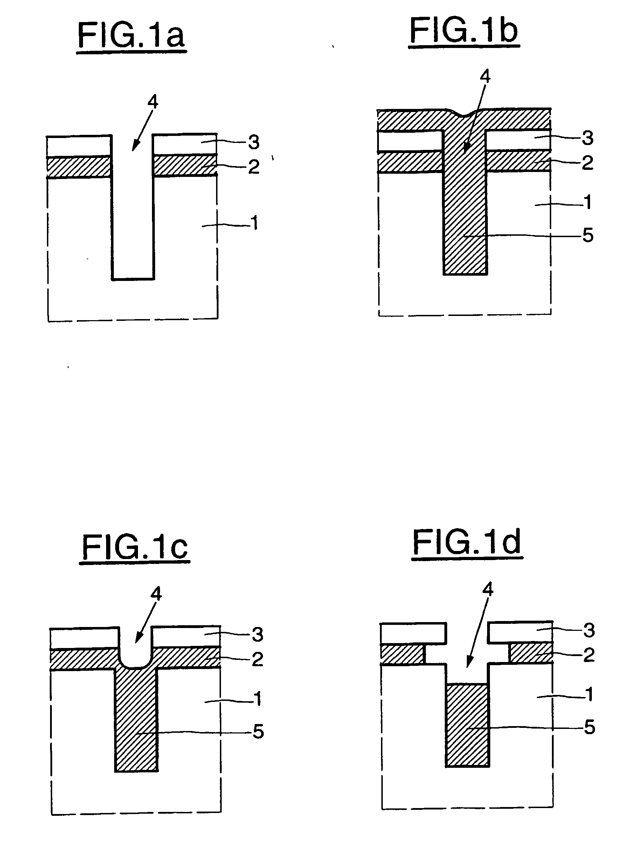

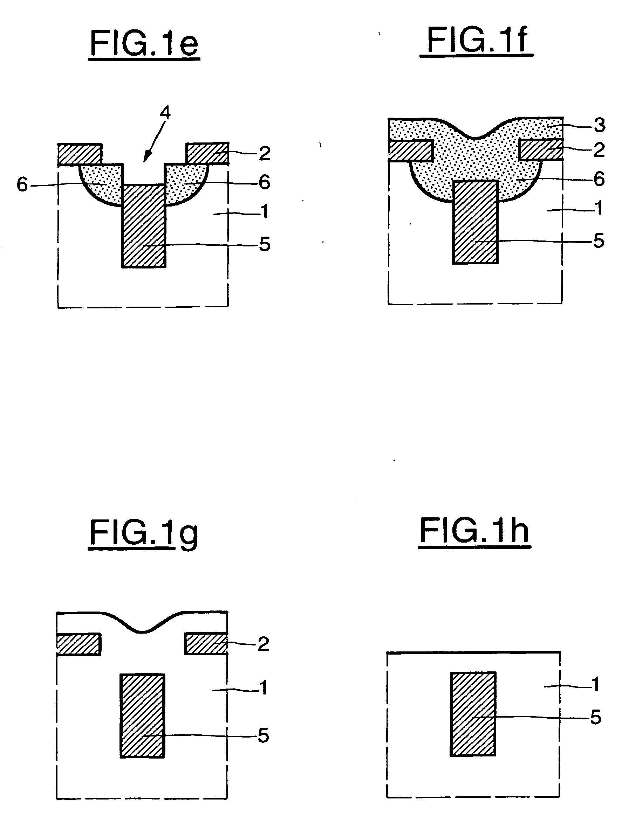

Le substrat de départ du procédé de l'invention, ou substrat initial 1, est illustré sur la figure 1a et comporte ici au moins une tranchée étroite. Cette tranchée peut être profonde ou peu profonde. Elle peut être réalisée, selon une mise en oeuvre du procédé de l'invention, par dépôt dans un premier temps d'une couche d'oxyde de silicium 2 sur le substrat initial en silicium monocristallin 1. L'épaisseur de cette couche 2 peut varier entre 0,01 micron et 1 micron, et est de préférence de l'ordre de 2000 Å.

On dépose ensuite sur l'oxyde 2 une couche de nitrure de silicium 3. L'épaisseur de cette couche 3 peut également varier entre 0,01 micron et 1 micron, et est également de préférence de l'ordre de 2000 Å.

On grave ensuite de façon anisotrope et de manière classique, tout d'abord le nitrure 3 et l'oxyde 2, puis finalement le silicium monocristallin du substrat 1 à l'aide d'une opération de photolithographie, pour former la tranchée 4.

La tranchée 4 a une profondeur comprise entre 1 et 15µm et de largeur variable, de préférence inférieure à 1µm.

Selon le procédé de l'invention, on remplit ensuite la tranchée 4 ainsi gravée avec le matériau de remplissage approprié à l'usage que l'on souhaite faire de cette tranchée.

Selon une première variante, on réalise une tranchée isolante en vue, par exemple, de séparer des couches enterrées contiguës de conductivité inverse.

Ainsi, selon cette variante du procédé de l'invention, on remplit la tranchée 4 avec un matériau diélectrique. Comme matériau diélectrique, on choisit de préférence de l'oxyde de silicium.

Le remplissage de la tranchée avec l'oxyde de silicium 5 peut se faire de différentes façons classiques.

On peut envisager le dépôt d'oxyde de silicium conforme comme l'illustre la figure 1b. L'oxyde se dépose alors également sur toute la surface de la plaquette.

On préférera toutefois utiliser le dépôt d'oxyde de silicium par oxydation thermique comme cela est illustré à la figure 1c. D'une part, il s'agit là d'une méthode plus adaptée à la présence de tranchées éventuellement étroites. D'autre part, on obtient un oxyde plus dense qu'avec le dépôt conforme. Par ailleurs, dans la mesure où l'oxyde de silicium ne croît que sur le silicium, seule la tranchée 4, légèrement élargie par l'oxydation du silicium des parois, est remplie d'oxyde.

Conformément au procédé de l'invention, on effectue ensuite une désoxydation contrôlée, et essentiellement de manière à former sous la couche de nitrure de silicium 3 deux cavités latérales de largeur donnée dans la couche d'oxyde 2 comme l'illustre la figure 1d. Dans le cadre de la première variante du procédé de l'invention, on retire également une partie de l'oxyde de silicium 5 dans la tranchée 4 et, le cas échéant, la couche d'oxyde de silicium en surface de la plaquette.

Cette désoxydation s'effectue par gravure isotrope à l'acide fluorhydrique ou encore par gravure plasma isotrope au fluor.

On retire ensuite de manière classique la couche de nitrure de silicium.

L'étape suivante du procédé de l'invention est illustrée à la figure le et consiste à amorphiser le silicium découvert. Il s'agit du silicium monocristallin du substrat initial 1 découvert par l'étape de désoxydation. Ces zones sont référencés 6. L'amorphisation est localisée et auto-alignée sur la tranchée. L'amorphisation s'effectue de manière classique par destruction du réseau cristallin du silicium, par exemple par implantation de particules lourdes telles que les ions. Dans le cadre de l'invention, on préférera notamment l'implantation d'ions fluorure.

Selon le procédé de l'invention, et tel qu'illustré à la figure 1f, on dépose ensuite une couche de silicium amorphe 7 de manière à au moins combler les cavités latérales et l'évidement au-dessus de la tranchée 4. Le dépôt de silicium amorphe se fait de manière classique à basse température. On peut par exemple utiliser un four LPCVD (dépôt chimique basse pression) en injectant du silane à température suffisamment faible, par exemple inférieure à 600°C, typiquement à 400°C.

La figure 1g illustre une mise en oeuvre particulière de l'invention selon laquelle on effectue un recuit préalablement aux étapes d'égalisation de la surface du substrat. Le recuit thermique permet de recristalliser le silicium amorphe en créant une ré-épitaxie du silicium amorphe 6, 7 à partir du silicium monocristallin du substrat initial 1. La restructuration du réseau de silicium monocristallin conduit à la figure 1g où la précédente couche de silicium amorphe se fond maintenant avec le silicium monocristallin du substrat 1.

Il convient de noter ici que selon l'invention, la zone 6 est spatialement limitée, et la frontière entre cette zone 6 et le substrat 1 est facilement localisée par l'implantation ionique. Cette frontière est par ailleurs une frontière « douce », c'est à dire que le passage de l'état Si monocristallin à l'état Si amorphe est très progressif. Ces caractéristiques conduisent à un bon rendement de recristallisation de la zone 6, et à une recristallisation sans défauts, que l'on peut difficilement obtenir avec une surface à recristalliser importante.

On effectue ensuite un polissage mécano chimique s'arrêtant sur la couche d'oxyde de silicium 2 pour retirer la couche de silicium recristallisé en surface de la plaquette. On élimine ensuite de manière classique la couche d'oxyde de silicium 2. Puis, afin de planifier la surface, on soumet la plaquette à un ultime polissage mécano chimique.

Après cette succession d'étapes, on obtient, selon la première variante du procédé de l'invention, un substrat final en silicium monocristallin 1 présentant une surface monocristalline parfaitement plane et uniforme sur laquelle il sera possible de réaliser une épitaxie exempte de défaut. Ce substrat semi conducteur comporte une tranchée isolante enterrée référencée 5 sur la figure 1h.

Selon une deuxième variante, on peut réaliser un substrat en silicium dont la surface est uniformisée selon le procédé de l'invention et qui comporte, réalisée dans une tranchée, une capacité enterrée.

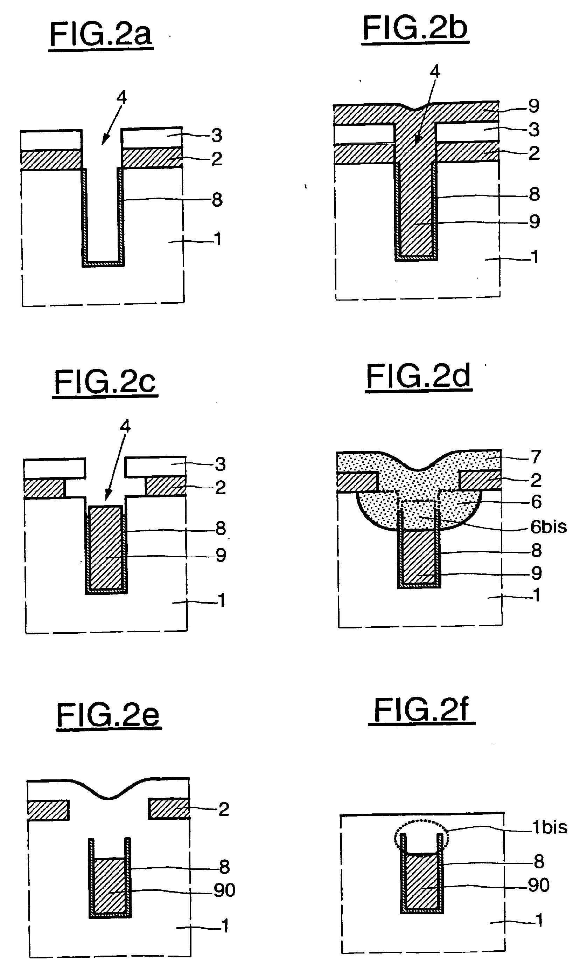

En vue de la réalisation d'un tel substrat, on réalise tout d'abord une tranchée 4 dans le substrat 1 tel qu'illustré à la figure la conformément à ce qui précède. On effectue ensuite une oxydation thermique contrôlée de manière à former sur les parois de la tranchée 4 une couche d'oxyde de silicium 8 d'épaisseur comprise entre 40 et 1000 Å, de préférence entre 50 et 300 Å. on obtient le dispositif illustré à la figure 2a.

On dépose ensuite sur la plaquette et de manière à remplir la tranchée 4, du silicium polycristallin 9 fortement dopé. Le dopage du silicium est réalisé in situ.

On obtient un dispositif tel qu'illustré à la figure 2b.

Conformément au procédé de l'invention, on grave ensuite le silicium polycristallin 9, déposé précédemment, au moins de manière à le retirer de la surface de la plaquette. Par ailleurs, cette gravure est menée jusqu'à ce que le niveau du silicium polycristallin dans la tranchée 4 soit en dessous de la surface du substrat initial 1.

L'étape suivante consiste en une désoxydation contrôlée telle que décrite précédemment dans le cadre de la première variante. On obtient alors le dispositif illustré à la figure 2c sur laquelle la tranchée est tapissée d'une couche d'oxyde de silicium 8 dont la hauteur est inférieure à la hauteur de la couche de silicium polycristallin dopé 9 dans la tranchée 4. Deux cavités latérales de largeur donnée apparaissent, sous la couche de nitrure de silicium 3, dans la couche d'oxyde de silicium 2.

On retire ensuite de manière classique le masque de nitrure de silicium 3.

Conformément au procédé de l'invention, on amorphise ensuite le silicium découvert.

Dans le cadre de cette deuxième variante du procédé de l'invention, le silicium découvert à ce stade du procédé est le silicium monocristallin du substrat 1, ainsi que la partie émergente de silicium polycristallin dopé 9 dans la tranchée 4. On crée ainsi des zones de silicium amorphe référencées 6 et 6bis.

L'amorphisation est localisée et auto-alignée sur la tranchée. On dépose ensuite sur toute la surface de la plaquette une couche de silicium amorphe 7 conformément à ce qui a été décrit plus haut dans le cadre de la première variante. On obtient alors le dispositif illustré à la figure 2d, sur laquelle dans une tranchée 4 gravée dans un substrat 1, un bloc de silicium polycristallin 9 est partiellement enveloppé dans une couche d'oxyde de silicium 8. La hauteur de ce bloc, inférieure à celle de la tranchée 4, est également inférieure à la hauteur de l'enveloppe d'oxyde de silicium 8. Cet élément est surmonté d'une zone de silicium amorphe comportant les zones de silicium amorphisé 6 et 6bis et le silicium amorphe 7 déposé. La couche amorphe 7 déposée a donc ici un rôle de liaison entre les régions 6 et 6bis ainsi que de rebouchage de la surface.

Conformément à une mise en oeuvre particulière du procédé de l'invention, et comme décrit plus haut dans le cadre de la première variante, on effectue un recuit thermique de manière à restaurer la structure cristalline du silicium amorphe. Comme l'illustre la figure 2e, le silicium recristallisé se confond avec le silicium monocristallin du substrat 1. L'amorphisation de la zone 6bis permet d'éviter une « remontée » de défauts cristallins dans la couche monocristalline à partir du silicium polycristallin.

Après les étapes d'égalisation de la surface du substrat, qui sont les mêmes que pour la première variante, on obtient un substrat en silicium monocristallin illustré à la figure 2f, dont la surface monocristalline parfaitement plane et uniforme permet la croissance épitaxiale sans défaut de silicium monocristallin. Le substrat comporte par ailleurs une capacité enterrée constituée de silicium polycristallin 90 fortement dopé partiellement enveloppé d'une paroi d'oxyde de silicium 8 le séparant latéralement du substrat 1. Au-dessus de cette capacité enterrée et dans le substrat 1, il subsiste une zone fortement dopée 1bis, de même conductivité que le silicium polycristallin 90. Cette zone correspond à la zone de silicium polycristallin amorphisée 6bis ainsi qu'à la partie de silicium 7 dopée par diffusion des dopants lors du recuit.

La destruction localisée selon l'invention du réseau cristallin avant sa restructuration, est particulièrement avantageuse pour des tranchées capacitives, car elle permet d'enterrer le silicium polycristallin 90 (toute la capacité) par une gravure contrôlée de l'oxyde de flanc 8, sans qu'il soit nécessaire de prévoir un oxyde supplémentaire.

Selon une troisième variante, il est également possible de réaliser une diode enterrée dans un substrat en silicium dont la surface est uniformisée conformément au procédé de l'invention en vue d'une épitaxie homogène permettant la réalisation de composants électroniques.

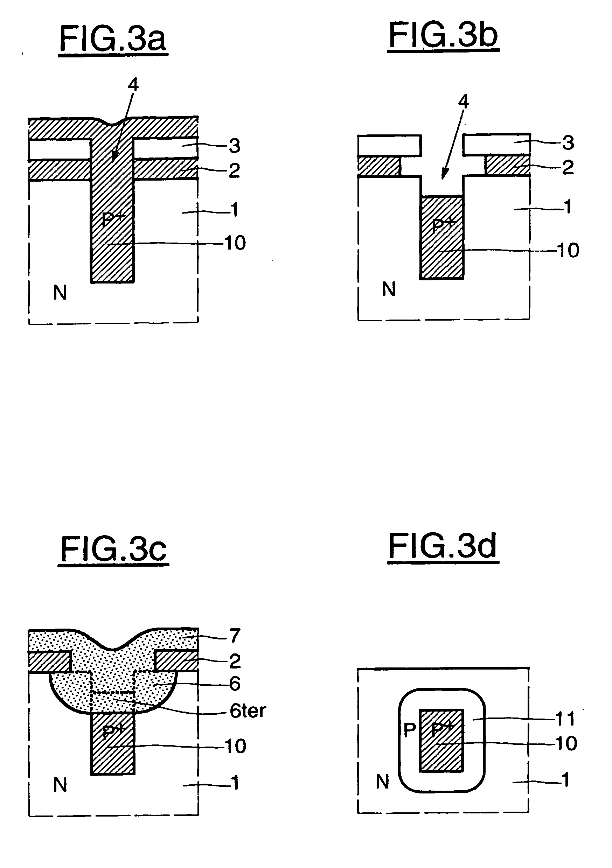

Selon cette variante, on dépose dans une tranchée réalisée conformément à ce qui précède du silicium polycristallin 10 fortement dopé. Selon le mode de réalisation illustré à la figure 3a, on a envisagé un substrat 1 dopé N et du silicium polycristallin 10 dopé P+. Toutefois, des conductivités inverses entrent également dans le cadre de l'invention.

On retire ensuite la couche de silicium polycristallin 10 formée en surface selon des méthodes habituelles. Le retrait du silicium polycristallin 10 est mené jusqu'à l'obtention d'un niveau de remplissage qui soit inférieur à la surface du substrat 1.

Cette étape est suivie, conformément au procédé de l'invention, par une désoxydation contrôlée. Cette désoxydation est plus amplement décrite plus haut dans le cadre de la première variante. On obtient alors le dispositif illustré à la figure 3b.

Conformément au procédé de l'invention, on retire ensuite la couche de nitrure de silicium 3 selon des méthodes classiques.

Puis on amorphise le silicium découvert. Dans le cas de cette troisième variante, le silicium découvert est composé des zones 6 du silicium monocristallin du substrat 1 apparent du fait de la désoxydation et de la gravure du silicium polycristallin remplissant la tranchée, ainsi que de la partie supérieure 6ter de ce matériau dans la tranchée. Là encore l'amorphisation est localisée et auto-alignée sur la tranchée.

On dépose ensuite selon les méthodes classiques une couche de silicium amorphe 7 de conductivité inverse à celle du silicium polycristallin 10 dans la tranchée 4. Cette couche se confond avec les zones de silicium amorphisé 6 et 6ter. On obtient alors le substrat illustré à la figure 3c.

Conformément au procédé de l'invention, on procède ensuite à un recuit thermique qui permet de recristalliser le silicium amorphe. Là encore, comme indiqué ci-avant pour les variantes précédentes, on évite la formation de défauts cristallins Dans le cadre de cette troisième variante, le recuit permet également la diffusion des dopants P+ dans le substrat N formant une enveloppe de silicium monocristallin 11 dopée P autour du silicium polycristallin 10 fortement dopé P+.

On procède ensuite, selon une mise en oeuvre particulière du procédé de l'invention, à l'égalisation de la surface du substrat 1 par retrait de la couche d'oxyde de silicium 2 et polissage mécano chimique de la plaquette.

On obtient alors le substrat illustré à la figure 3d (vue en coupe) qui présente une surface monocristalline parfaitement plane et uniforme permettant une épitaxie homogène de silicium monocristallin. Le substrat comporte en outre une diode enterrée constituée d'une zone fortement dopée P+ entièrement entourée d'une enveloppe d'épaisseur donnée dopée P.

La possibilité de réaliser un substrat en silicium comportant tranchées isolantes enterrées ou composants enterrés, et dont la surface est parfaitement plane et uniforme ouvre de nouveaux horizons à la réalisation de dispositifs semi conducteurs.

Comme cela a été évoqué précédemment, des substrats comportant des tranchées isolantes peuvent être avantageusement utilisés pour la réalisation de dispositifs semi conducteurs comportant plusieurs transistors adjacents. Non seulement ces dispositifs ne présentent pas ou très peu de risques d'abaissement de la tension de claquage ou de perçage des couches enterrées, mais encore la couche épitaxiale de silicium monocristallin dans laquelle sont réalisés les transistors, exempts de défaut cristallin, est appropriée à la réalisation de tout type de modules architecturaux.

L'uniformisation selon l'invention de la surface de substrat comportant des éléments enterrés réalisés dans des tranchées, présente l'avantage de pouvoir réaliser sur de tels substrats des dispositifs extrêmement fiables et performant, et moins encombrants. Ce deuxième aspect est particulièrement intéressant si on considère la diminution constante des dimensions des circuits intégrés, ainsi que leur degré d'intégration élevé.

## Revendications

1. Procédé de fabrication d'un substrat monocristallin semiconducteur, dans lequel
a) on élabore un substrat initial monocristallin (1) présentant localement et en surface au moins une discontinuité (4) du réseau cristallin,
b) on évide le substrat initial au niveau de la discontinuité,
c) on amorphise le réseau cristallin en périphérie de l'évidement,
d) on dépose sur la structure obtenue à l'étape c) une couche de matière amorphe ayant la même composition chimique que celle du substrat initial,
e) on effectue un recuit thermique de la structure obtenue à l'étape d) afin de recristalliser la matière amorphe en continuité avec le réseau monocristallin du substrat initial.

2. Procédé selon la revendication 1, **caractérisé par le fait qu'**il comprend, préalablement ou postérieurement à l'étape e), une étape d'aplanissement de surface.

3. Procédé selon la revendication 2, **caractérisé par le fait que** l'étape d'aplanissement comporte un polissage mécano-chimique.

4. Procédé selon l'une des revendications précédentes, **caractérisé par le fait que** le substrat initial comporte au moins un matériau pris dans le groupe formé par le silicium, le germanium, le carbure de silicium, l'arséniure de gallium,et un alliage de certains au moins des éléments précédents.

5. Procédé selon l'une des revendications précédentes, **caractérisé par le fait que** l'étape d'amorphisation comporte une implantation ionique localisée autour de l'évidement par une opération de masquage.

6. Procédé selon l'une des revendications précédentes, **caractérisé par le fait que** dans l'étape a), on dépose successivement sur le substrat initial (1) une première couche (2) d'un premier matériau et une deuxième couche (3) d'un deuxième matériau, puis on grave une tranchée (4) que l'on remplit avec un matériau de remplissage, ladite tranchée remplie formant ladite discontinuité de réseau cristallin,
et **par le fait que** dans l'étape b), on effectue une gravure sélective vis-à-vis de ladite deuxième couche (3), de la première couche et d'une partie supérieure du matériau de remplissage de la tranchée, de façon à former des cavités latérales et ledit évidement au niveau de la discontinuité cristalline, et on retire ladite deuxième couche (2).

7. Procédé selon la revendication 6, **caractérisé par le fait que** le matériau de remplissage comporte au moins un élément pris dans le groupe formé par le silicium, un oxyde de silicium, un nitrure de silicium.

8. Procédé selon la revendication 6, **caractérisé par le fait que** la tranchée est au moins partiellement remplie d'un matériau de remplissage isolant.

9. Procédé selon la revendication 6, **caractérisé par le fait que** le remplissage s'effectue par dépôt conforme d'oxyde de silicium.

10. Procédé selon la revendication 6, **caractérisé en ce que** le remplissage s'effectue par oxydation thermique du silicium.

11. Procédé selon l'une des revendication 6 à 10, **caractérisé en ce que** dans l'étape a), on réalise dans la tranchée (4) une capacité enterrée.

12. Procédé selon la revendication 11, **caractérisé en ce que** dans l'étape a), le remplissage de la tranchée comprend les étapes suivantes :
- on tapisse les parois de la tranchée (4) avec de l'oxyde (8) par oxydation thermique ;
- on dépose du silicium polycristallin (9) fortement dopé dans la tranchée (4) de manière à la remplir ;
- on grave le silicium polycristallin (9) déposé précédemment de manière à ce que le niveau de remplissage de la tranchée (4) soit en dessous de la surface du substrat initial (1).

13. Procédé selon l'une des revendication 6 à 10, **caractérisé en ce que** dans l'étape a), on réalise dans la tranchée (4) une diode enterrée.

14. Procédé selon la revendication 13, **caractérisé en ce que** dans l'étape a), le remplissage de la tranchée comprend les étapes suivantes :
- on dépose du silicium polycristallin (10) fortement dopé dans la tranchée (4) de manière à la remplir ;
- on grave le silicium polycristallin (10) déposé précédemment de manière à ce que le niveau de remplissage de la tranchée (4) soit en dessous de la surface du substrat initial (1).

15. Procédé selon l'une des revendications 6 à 14, **caractérisé par le fait que** l'amorphisation est auto-alignée sur la tranchée.

## Claims

1. Process for fabricating a semiconductor single-crystal substrate, in which:
a) an initial single-crystal substrate (1) having, locally and on the surface, at least one discontinuity (4) in the crystal lattice is formed;
b) the initial substrate is recessed at the discontinuity;
c) the crystal lattice is amorphized around the periphery of the recess;
d) a layer of amorphous material having the same chemical composition as that of the initial substrate is deposited on the structure obtained in step c);
e) the structure obtained in step d) is thermally annealed in order to recrystallize the amorphous material so as to be continuous with the single-crystal lattice of the initial substrate.

2. Process according to claim 1, **characterized in that** it comprises, prior or subsequent to step e), a surface planarization step.

3. Process according to claim 2, **characterized in that** the planarization step comprises a chemical-mechanical polishing step.

4. Process according to one of the preceding claims, **characterized in that** the initial substrate comprises at least one material from the group formed by silicon, germanium, silicon carbide, gallium arsenide and an alloy of at least some of the above elements.

5. Process according to one of the preceding claims, **characterized in that** the amorphizing step comprises a localized ion implantation around the recess by a masking operation.

6. Process according to one of the preceding claims, **characterized in that** in step a), a first layer (2) of a first material and a second layer (3) of a second material are deposited in succession on the initial substrate (1) and then a trench (4) is etched and filled with a fill material, said filled trench forming said crystal lattice discontinuity
and **in that**, in step b), the first layer and an upper portion of the trench fill material are selectively etched with respect to said second layer (3) so as to form lateral cavities and said recess at the crystal discontinuity, and said second layer is removed (2).

7. Process according to claim 6, **characterized in that** the fill material comprises at least one element from the group formed by silicon, a silicon oxide and a silicon nitride.

8. Process according to claim 6, **characterized in that** the trench is at least partly filled with an insulating fill material.

9. Process according to claim 6, **characterized in that** the filling is carried out by depositing silicon oxide as a conformal coating.

10. Process according to claim 6, **characterized in that** the filling is carried out by thermal oxidation of the silicon.

11. Process according to one of claims 6 to 10, **characterized in that**, in step a), a buried capacitor is formed in the trench (4).

12. Process according to claim 11, **characterized in that**, in step a), the trench filling operation comprises the following steps:
- the walls of the trench (4) are lined with oxide (8) by thermal oxidation;
- highly doped polycrystalline silicon (9) is deposited in the trench (4) so as to fill it;
- the previously deposited polycrystalline silicon (9) is etched so that the fill level of the trench (4) is below the surface of the initial substrate (1).

13. Process according to one of claims 6 to 10, **characterized in that**, in step a), a buried diode is formed in the trench (4).

14. Process according to claim 13, **characterized in that**, in step a), the trench filling operation comprises the following steps:
- highly doped polycrystalline silicon (10) is deposited in the trench (4) so as to fill it;
- the previously deposited polycrystalline silicon (10) is etched so that the fill level of the trench (4) is below the surface of the initial substrate (1).

15. Process according to one of claims 6 to 14, **characterized in that** the amorphization is self-aligned with respect to the trench.

## Patentansprüche

1. Verfahren zur Herstellung eines monokristallinen Halbleitersubstrats, in welchem
a) ein monokristallines Startsubstrat (1), das lokal und an der Oberfläche mindestens eine Diskontinuität (4) des Kristallgitters aufweist, gefertigt wird,
b) das Startsubstrat an der Diskontinuität ausgehöhlt wird,
c) das Kristallgitter am Rand der Aushöhlung amorphisiert wird,
d) auf die im Schritt c) gewonnene Struktur eine amorphe Materialschicht aufgebracht wird, die die gleiche chemische Zusammensetzung hat wie das Startsubstrat, und
e) eine thermische Behandlung der im Schritt d) gewonnenen Struktur durchgeführt wird, um das amorphe Material in Kontinuität mit dem monokristallinen Gitter des Startsubstrats zu rekristallisieren.

2. Verfahren nach Anspruch 1, **dadurch gekennzeichnet, daß** vor oder nach dem Schritt e) ein Schritt zum Einebnen der Oberfläche vorgesehen ist.

3. Verfahren nach Anspruch 2, **dadurch gekennzeichnet, daß** der Einebnungsschritt ein mechanisch-chemisches Polieren aufweist.

4. Verfahren nach einem der vorstehenden Ansprüche, **dadurch gekennzeichnet, daß** das Startsubstrat mindestens ein Material aus der folgenden Gruppe aufweist: Silizium, Germanium, Siliziumcarbid, Galliumarsenid und eine Legierung mindestens einiger der vorstehenden Elemente.

5. Verfahren nach einem der vorstehenden Ansprüche, **dadurch gekennzeichnet, daß** der Amorphisierungsschritt eine um die Aushöhlung herum lokalisierte Ionenimplantation durch einen Maskenprozeß aufweist.

6. Verfahren nach einem der vorstehenden Ansprüche, **dadurch gekennzeichnet, daß** im Schritt a) auf das Startsubstrat (1) nacheinander eine erste Schicht (2) aus einem ersten Material und eine zweite Schicht (3) aus einem zweiten Material aufgebracht wird, dann ein Graben (4) geätzt wird, der mit einem Füllmaterial gefüllt wird, wobei der gefüllte Graben die Diskontinuität des Kristallgitters bildet, und
daß im Schritt b) ein selektives Ätzen bezüglich der zweiten Schicht (3), der ersten Schicht (2) und eines oberen Teils des Füllmaterials des Grabens durchgeführt wird, um laterale Hohlräume und die Aushöhlung am Ort der kristallinen Diskontinuität zu bilden, und die zweite Schicht (2) weggenommen wird.

7. Verfahren nach Anspruch 6, **dadurch gekennzeichnet, daß** das Füllmaterial mindestens ein Element aus der folgenden Gruppe aufweist: Silizium, ein Siliziumoxid und ein Siliziumnitrid.

8. Verfahren nach Anspruch 6, **dadurch gekennzeichnet, daß** der Graben zumindest teilweise mit einem isolierenden Füllmaterial gefüllt wird.

9. Verfahren nach Anspruch 6, **dadurch gekennzeichnet, daß** das Füllen durch eine gleichmäßige Abscheidung von Siliziumoxid erfolgt.

10. Verfahren nach Anspruch 6, **dadurch gekennzeichnet, daß** das Füllen durch thermische Oxidation des Siliziums erfolgt.

11. Verfahren nach einem der Ansprüche 6 bis 10, **dadurch gekennzeichnet, daß** im Schritt a) im Graben eine vergrabene Kapazität hergestellt wird.

12. Verfahren nach Anspruch 11, **dadurch gekennzeichnet, daß** im Schritt a) das Füllen des Grabens die folgenden Schritte aufweist:
- Bedecken der Wände des Grabens (4) mit dem Oxid (8) durch eine thermische Oxidation;
- Abscheiden von stark dotiertem polykristallinem Silizium (9) im Graben (4), um ihn zu füllen;
- Ätzen des zuvor abgeschiedenen polykristallinen Siliziums (9), so daß die Füllebene des Grabens (4) unterhalb der Oberfläche des Startsubstrats (1) ist.

13. Verfahren nach einem der Ansprüche 6 bis 10, **dadurch gekennzeichnet, daß** im Schritt a) im Graben (4) eine vergrabene Diode hergestellt wird.

14. Verfahren nach Anspruch 13, **dadurch gekennzeichnet, daß** im Schritt a) das Füllen des Grabens die folgenden Schritte aufweist:
- Abscheiden von stark dotiertem polykristallinem Silizium (10) im Graben (4), um ihn zu füllen;
- Ätzen des zuvor abgeschiedenen polykristallinen Siliziums (10), so daß die Füllebene des Grabens (4) unterhalb der Oberfläche des Startsubstrats (1) ist.

15. Verfahren nach einem der Ansprüche 6 bis 14, **dadurch gekennzeichnet, daß** sich die Amorphisierung von selbst am Graben ausrichtet.
